# EUROPEAN PATENT APPLICATION

(11) **EP 0 653 500 A1**
(43) Date of publication of application: **17.05.1995**
(21) Application number: 94480112.5
(22) Date of filing: 26.10.1994
(51) Int. Cl.: C23C 16/44, C30B 25/14

(54) **CVD reactor for improved film thickness uniformity deposition**

(30) Priority: 12.11.1993 US 153003
(71) Applicant: INTERNATIONAL BUSINESS MACHINES CORPORATION, Armonk, N.Y. 10504 (US)
(72) Inventor: Barbee, Steven George, Dover Plains, NY 12522 (US); Conti, Richard Anthony, Mt. Kisco, NY 10549 (US); Chapple-Sokol, Jonathan Daniel, Poughkeepsie, NY 12603 (US); Kotecki, David Edward, Hopewell Junction, NY 12533 (US); Wilson, Donald Leslie, New Windsor NY 12553 (US); Zuhoski, Steven Paul, Rowlett, Texas 75988 (US); Chow Wong, Justin Wai, South Burlington, Vermont 05403 (US)
(74) Representative: de Pena, Alain

(57) **Abstract**

A chemical vapor deposition reactor (50) comprises in combination a nozzle (52) and means (54) for equalizing a reactant chemistry and a flux of reactants. The nozzle is disposed within a chamber (15) opposite a susceptor (14) upon which a substrate (56) is supported during chemical deposition of a film upon a surface of the substrate from a reactant gas released into the chamber by the nozzle. The nozzle comprises an inlet port (58) for receiving the reactant gas from a gas supply and an outlet port (60) for releasing the reactant gas therethrough. The equalizing means substantially equalizes a reactant chemistry and a flux of reactants uniformly across the surface of the substrate.

## Description

The present invention generally relates to improved apparatus for chemical vapor deposition, and more particularly, to an improved injector for use in such apparatus.

The formation of thin films by chemical vapor deposition (CVD) and low pressure chemical vapor deposition (LPCVD) continues to be a key process step in silicon based microelectronics and in the semiconductor industry. Many new processes utilize complex reagents, such as, metal organic precursors (i.e., metal organic CVD (MOCVD) reagents), in which respective chemical pathways for film formation are not yet well understood. Nominally, films formed from these complex reagents are deposited in single-wafer reactors, which in many instances, are primarily designed for the deposition of materials having less complex chemistries. Presently available reactors suffer from an inability to accommodate the new reagents and further suffer from the inability to achieve optimal film properties.

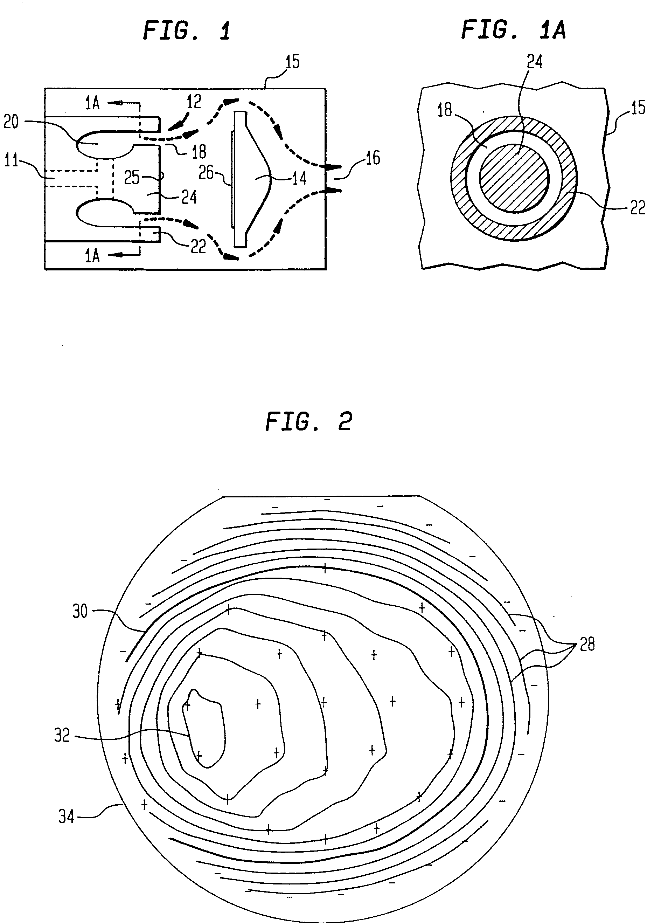

Figs. 1 and 1A illustrate one type of prior art apparatus for forming CVD and LPCVD films on semiconductor wafer surfaces, such films as aluminum oxide (Al₂O₃) or tungsten (W) films, for example. In this prior art apparatus, a single injector indicated by the general reference numeral 12 is located directly in front of a susceptor 14 and injects a vapor into a chamber 15. Undeposited vapor exits through a port 16 on an opposite side of the susceptor from the injector 12.

The injector 12 has a generally unrestricted angular passage 18 through which vapor flows from a plenum 20 into the chamber 15. A passage 11 connects the plenum to an external vapor supply. The passage 18 is formed between an outer ring 22 and a central cylindrical member 24 that has a flat surface 25 forming a wall in front of the susceptor 14. The outer edge of the passage 18 is coextensive with the outer periphery of a wafer 26 held by the susceptor 14. The dashed arrows in the figure show generally the vapor flow path.

The apparatus of the type illustrated in Fig. 1 exhibits a major shortcoming, namely, poor film thickness uniformity and uniformity of film properties across the surface of a single wafer for certain reactant gases. This is primarily due to non-uniform reactant chemistry and non-uniform flux of reactants in the reaction chamber during film deposition. To gain a better appreciation for the above, a reactant gas is a gas suitable for undergoing chemical reactions. Reactant chemistry is a series of chemical reactions or combination of chemical reactions forming products, the chemical reactions occurring i) in a reactant gas as the gas travels between an injector and a susceptor, and ii) on the surface of the susceptor or a wafer supported on the susceptor. Reactants are the combination of a reactant gas plus any products produced by a reactant chemistry. Lastly, flux of reactants is a rate at which products are produced by the chemical reactions of a reactant chemistry.

The apparatus of Fig. 1 is not well suited for providing a uniform reactant chemistry and flux of reactants in a reaction chamber during film deposition using reactant gases such as metal organics. This results in poor film thickness uniformity as shown in Fig. 2. In particular, Fig. 2 is representative of a film thickness uniformity distribution map of measured thicknesses of a typical Al₂O₃ film deposited on a wafer using the apparatus of Fig. 1. In Fig. 2, contoured lines 28 are representative of respective regions of constant thickness. The plus (+) signs and the minus (-) signs are representative of thicknesses, above and below, respectively, a mean or median thickness. The median thickness of Fig. 2 is represented by the bold solid line indicated by 30. Note that only one mean thickness exists in Fig. 2. The film thickness as shown in Fig. 2 is found to decrease monotonically from a thickest area, as indicated by the numeral 32 and which is located substantially off of the wafer center, towards a side edge 34 of the wafer. In addition to the monotonically decreasing film thickness, the thickness portion of the film is not centered upon the wafer, thereby making the film thickness distribution lop-sided. Such non-centered thickness distribution of the film is undesirable. Furthermore, in the film thickness uniformity distribution map of Fig. 2, the thickness variation, measured with a 49 point surface map, has a standard deviation of eleven percent (11%). It should be noted that such deviation in thickness uniformity of between 10-15% or higher for a CVD deposited film is highly undesirable for the production of thin films.

In addition to the disadvantages of the Fig. 1 apparatus listed above, the Fig. 1 apparatus further suffers from the inability to adjust or tailor the uniformity profile obtainable thereby. That is, the Fig. 1 apparatus provides no flexibility for adjusting the injector to achieve a uniform reactant chemistry and flux of reactants across the surface of a wafer for certain reactant gases.

There is thus needed an apparatus for providing improved film thickness uniformity across the surface of a single wafer, the thickness uniformity further being centered on the wafer. In addition, an apparatus for providing a uniform concentration of reactants to a wafer surface to ensure consistent film properties at all locations across the wafer is highly desirable. Such an apparatus should further be adaptable for providing a desired film thickness uniformity appropriate for a particular film deposition.

An object of the present invention is the provision of an improved injector for use with CVD and LPCVD systems of the type generally illustrated in Fig. 1; an injector that provides improved uniformity of reactants across the surface of a single wafer, and thus improved uniformity of a deposited film across the surface of the single wafer.

An object of the present invention is to provide an apparatus capable of providing improved film thickness uniformity across a single wafer.

Another object of the present invention is to provide an apparatus for providing a uniform concentration of reactants to a wafer surface to ensure consistent film properties and uniform film thickness at all locations across a wafer.

According to the invention, a chemical vapor deposition reactor comprises in combination a nozzle and a means for equalizing a reactant chemistry and a flux of reactants. The nozzle is disposed within a chamber opposite a susceptor upon which a substrate is supported during chemical deposition of a film. The nozzle comprises an inlet port for receiving a reactant gas from a gas supply and an outlet port for releasing the reactant gas therethrough. The equalizing means substantially equalizes a reactant chemistry and a flux of reactants uniformly across the surface of the substrate, the equalizing means being positioned intermediate the nozzle and a susceptor.

The foregoing and other teachings of the present invention will become more apparent upon a detailed description of the best mode for carrying out the invention as rendered below. In the description to follow, reference will be made to the accompanying drawings, where like reference numerals are used to identify like parts in the various views and in which:
Figs. 1 and 1A are a schematic view, with parts in section, of prior art CVD and LPCVD apparatus and a sectional view along the line A-A of Fig. 1, respectively;
Fig. 2 shows a film thickness uniformity distribution obtained using the apparatus of Fig. 1;
Figs. 3 and 3A are a schematic view, with parts in section, of an injector in accordance with the teachings of the present invention and a sectional view along the line A-A of Fig. 3, respectively;
Fig. 4 shows a film thickness uniformity distribution obtained using the embodiment of the present invention of Fig. 3;
Fig. 5 is a sectional view of an alternate embodiment of the present invention; and
Fig. 6 is a sectional view of yet another alternate embodiment of the present invention.

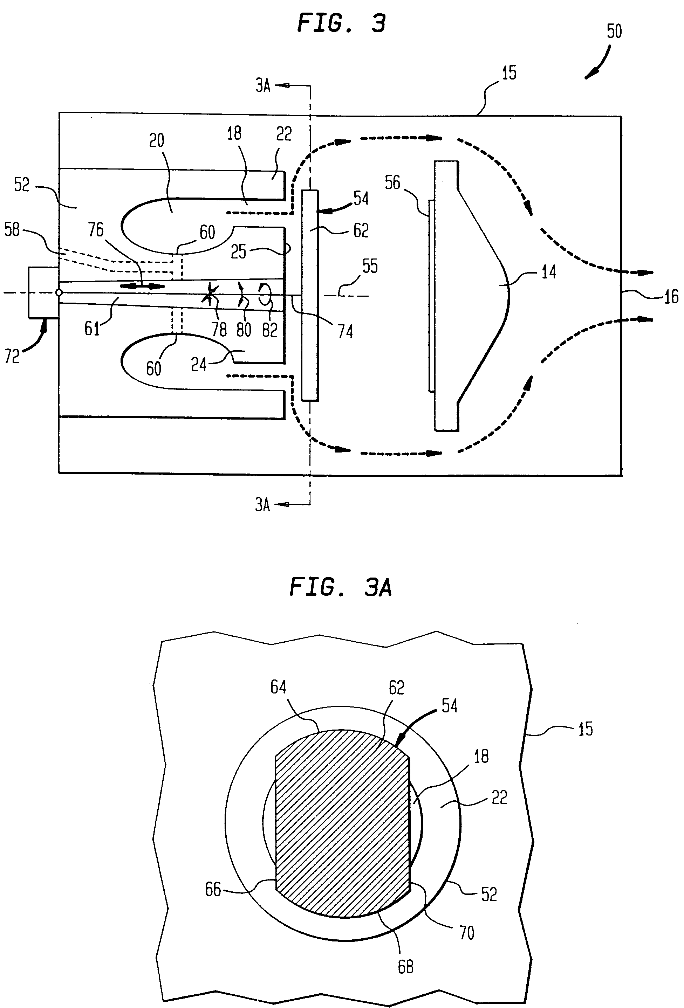

Referring now to FIG. 3 and FIG. 3A, in accordance with the teachings of this invention, a CVD reactor 50 comprises a nozzle 52 and a means 54 for substantially equalizing a reactant chemistry and a flux of reactants, the reactant gas undergoing a reactant chemistry and thus producing a flux of reactants within reactor 50. Nozzle 52 has a principal axis 55 and is disposed within chamber 15 opposite susceptor 14 upon which a substrate or wafer 56 is supported during chemical deposition of a film. Nozzle 52 is securably attached to a wall of chamber 15, rendering nozzle 52 immobile. Nozzle 52 further comprises an inlet port 58 for receiving a reactant gas from a gas supply (not shown). In addition, nozzle 52 further comprises an outlet port 60 for releasing a reactant gas received through inlet port 58, therethrough, and into the chamber 15 via plenum 20 and passage 18.

Passage 18 is formed between outer ring 22 and central cylindrical member 24. Outer ring 22 and central cylindrical member 24 are concentric about principal axis 55. Nozzle 52 also includes a passage 61 extending from the end of nozzle 52 attached to the wall of chamber 15 to an opposite side of nozzle 52 thereof. In a preferred embodiment, passage 61 comprises a tapered conically shaped passage, extending from a first end having a first cross-sectional area to a second end having a second cross-sectional area, wherein the second cross-sectional area is larger than the first cross-sectional area.

In a preferred embodiment, equalizing means 54 comprises a plate 62 of a prescribed thickness having a contoured shape about its perimeter (FIG. 3A). The contoured shape is characterized by a plurality of side edge portions 64, 66, 68, and 70, for example. Each of the side edge portions have a prescribed curvature, wherein at least two of the plurality of side edge portions do not form a part of a circle having a same finite radius. For example, side edge portion 64 has a prescribed curvature of a circle having a first radius, whereby side edge portion 64 constitutes a curved side edge portion. Side edge portion 66 has a prescribed curvature which is straight, whereby side edge portion 66 constitutes a straight side edge portion. Side edge portion 68 is similar to side edge portion 64. Likewise, side edge portion 70 is similar to side edge portion 66.

The plurality of side edge portions of plate 62 can further be characterized by paired side edge portions, wherein a respective set of paired side edge portions comprise side edge portions of substantially the same curvature. Still further, the plurality of side edge portions can further comprise at least one respective set of paired side edge portions comprising straight side edge portions, such as 66 and 70, and at least one respective set of paired side edge portions comprising curved side edge portions, such as 64 and 68, for example.

Referring once again to FIG. 3, equalizing means 54 is coupled to nozzle 52 to be intermediate nozzle 52 and susceptor 14. More particularly, equalizing means 54 is coupled to nozzle 52 via a positioning means 72, such that equalizing means 54 is proximate surface 25 and intermediate nozzle 52 and susceptor 14. Positioning means 72 is attached to nozzle 52 at the wall of chamber 15 proximate the first end of passage 61, the chamber wall having an appropriate aperture therein. A shaft 74 of positioning means 72 extends through passage 61, wherein equalizing means 54 is affixed at an end of shaft 74.

Positioning means 72 comprises a precision manipulator, and more preferably, a vacuum compatible precision manipulator, such as a commercially available precision manipulator, model PM-275, manufactured by Huntington Laboratories, Inc. of Mountain View, California. This type of precision manipulator provides X-Y-Z translation, rotary motion, and off-axis tilt. Other types of manipulators suitable for operation under vacuum conditions could be used as well. Positioning means 72 provides: linear translation in a direction indicated by arrow 76; X-Y translation in a plane perpendicular to the principal axis 55 of nozzle 52 as indicated by arrows 78; pivotal motion about a point along an axis parallel to the principal axis 55 of nozzle 52 as indicated by arrow 80; and rotational motion about an axis parallel to the principal axis 55 of nozzle 52 as indicated by arrow 82.

The operation of the present invention shall be described hereinbelow with reference to an example film deposition of Al₂O₃. Silicon wafer 56 is situated on a resistively heated susceptor 14 which is maintained at a fixed temperature. Appropriate reactant gases are injected into the reactor chamber 15 through nozzle 52. With the nozzle 52 and equalizing means 54 of the present invention, the region where the reactant gases are injected into the chamber 15 is advantageously moved further away from the center of the wafer 56. The reactant gas flows outward from the injector, towards wafer 56 and susceptor 14, and then proceeds around the susceptor to an exhaust port 16. The dashed arrows in FIG. 3 show generally the vapor flow path. With the present invention, the concentration of film-forming species, that is, reactants, to the wafer surface are selectively controlled and tailored using positioning means 72 and equalizing means 54 to advantageously provide improved film uniformity and uniformity of film properties across the surface of the wafer. In other words, the reactant chemistry and flux of reactants are substantially equalized uniformly across the surface of the wafer, thereby resulting in highly improved uniform film deposition and uniform film properties. The contoured shape of plate 62 advantageously assists in the equalizing of the reactant chemistry and the flux of reactants uniformly across the surface of the wafer in a particular chamber. The particulars of the contoured shape of plate 62 are dependent in part upon the geometries of obstructions found within a particular chamber, whereby undesirable influences in gas flow patterns caused by such obstructions are advantageously and easily compensated for.

During the course of film deposition, the temperature of the equalizing means 54, in particular, plate 62, may increase due to heat transported from the susceptor 14 and/or wafer 56. To ensure no undesirable deposition of the film onto the equalizing means 54, appropriate cooling of equalizing means may be necessary. Such cooling can be implemented by the presence of cooling channels within the manipulator shaft 74 and the plate 62, the cooling channels being fed with a cooling gas, for example. In this manner, the surfaces of the manipulator shaft 74 and plate 62 which are exposed internal to the chamber are maintained at a desired temperature. Nozzle 52 is temperature controlled by generally known methods in the art.

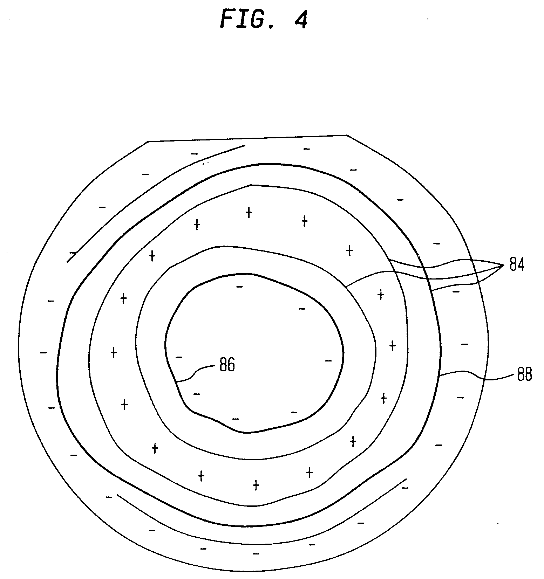

FIG. 4 is representative of a film thickness uniformity distribution map of measured thicknesses of the Al₂O₃ film deposited on a wafer using the apparatus of the present invention. Contoured lines 84 are representative of respective regions of constant film thickness. The (+) and (-) signs represent thicknesses above and below, respectively, a mean or median thickness. Note that the thickness distribution of FIG. 4 contains two regions of equal mean thickness indicated by numerals 86 and 88. The film thickness distribution is symmetric about the center of the wafer and the standard deviation of film uniformity is four and a half percent (4.5%). This symmetric film thickness distribution is substantially more uniform than that of FIG. 1, and is more highly desirable than that of FIG. 1.

Positioning of equalizing means 54 is advantageously adjusted using positioning means 72 to attain optimal film thickness uniformity of a deposited film in a particular chamber in combination with the reactant gases used. That is, positioning means 72 can adjustably space equalizing means 54 along a prescribed axis between a first prescribed distance and a second prescribed distance from surface 25 of nozzle 52. Positioning means 72 may also adjustably translate equalizing means 54 in a plane perpendicular to the principal axis 55 of nozzle 52. Positioning means 72 may further adjustably pivot equalizing means 54 about a prescribed point along an axis parallel to the principal axis 55 of nozzle 52. Lastly, positioning means 72 can adjustably rotate equalizing means 54 about a prescribed axis between a first angular position and a second angular position. Specific operation of precision manipulators has not been discussed herein, since the same is well known to one skilled in the art. Film thickness profiles of deposited films may now be advantageously selectively tailored and/or enhanced for the needs of a particular deposition chemistry.

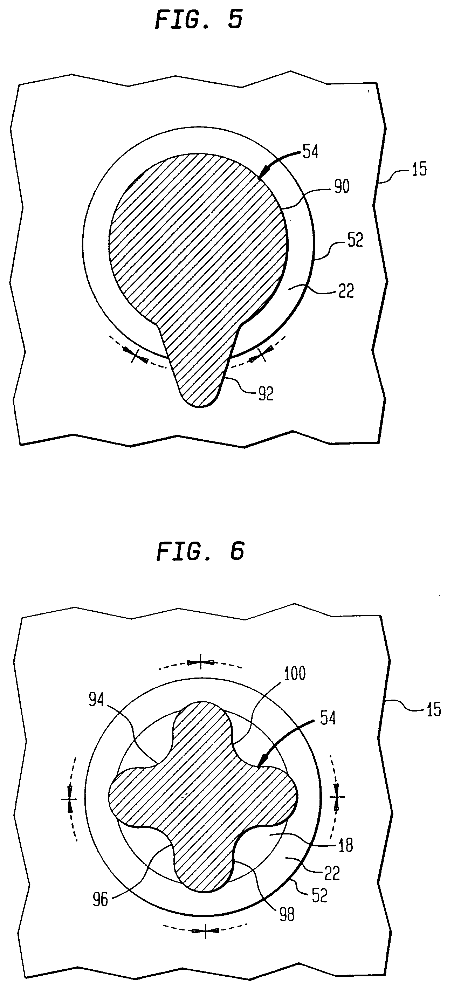

As discussed hereinabove, the specific contoured shape of plate 62 is dependent in part upon the geometries of obstructions found within a particular chamber, whereby undesirable influences in gas flow patterns caused by such obstructions are advantageously and easily compensated for. An alternate embodiment of an equalizing means 54 according to the present invention is shown in FIG 5. Here, the plurality of side edge portions of equalizing means 52 comprise a first side edge portion 90 and a second side edge portion 92, the first and second side edge portions 90 and 92, respectively, having prescribed curvatures different from one another, and further wherein the first and second side edge portions 90 and 92, respectively, do not form a part of a circle having a same finite radius.

FIG. 6 illustrates yet another alternate embodiment of the invention. Here, the plurality of side edge portions of equalizing means 52 comprise similar side edge portions 94, 96, 98, and 100. Each of these side edge portions have a prescribed curvature similar to one another, however, the side edge portions do not form a part of a circle having a same finite radius.

There has thus been shown an apparatus for providing improved film thickness uniformity across the surface of a single wafer, the thickness uniformity further being symmetric and centered on the wafer. In addition, the present invention provides a uniform concentration of reactants to a wafer surface to ensure consistent film properties, such as, electrical, mechanical, optical, etc., at all locations across the wafer. The CVD reactor according to the present invention further provides ease of adaptability for providing a desired film thickness uniformity appropriate for a particular film deposition.

While the invention has been particularly shown and described with reference to the preferred embodiment thereof, it will be understood by those skilled in the art that various changes in form and detail may be made therein without departing from the spirit and scope of the invention. For example, the present invention is applicable for different nozzle geometries.

## Claims

1. A chemical vapor deposition reactor comprising in combination:
a) a nozzle disposed within a chamber opposite a susceptor upon which a substrate is supported during chemical deposition of a film upon a surface of the substrate from a reactant gas released into the chamber by said nozzle, said nozzle having a principal axis, an inlet port for receiving the reactant gas from a gas supply and an outlet port for releasing the reactant gas therethrough, the reactant gas undergoing a reactant chemistry and producing a flux of reactants within the chamber; and,
b) means for substantially equalizing a reactant chemistry and a flux of reactants uniformly across the surface of the substrate.

2. The chemical vapor deposition reactor of claim 1 wherein said equalizing means coupled to said nozzle intermediate said nozzle and the susceptor.

3. The chemical vapor deposition reactor of claim 1 further comprising:
c) means for positioning said equalizing means intermediate said nozzle and the susceptor, said positioning means coupling said equalizing means to said nozzle.

4. The chemical vapor deposition reactor of claim 1 or 3 wherein said equalizing means comprises a plate having a contoured shape about its perimeter, the contoured shape characterized by a plurality of side edge portions, each of said side edge portions having a prescribed curvature, wherein at least two of said plurality of side edge portions do not form a part of a circle having a same finite radius.

5. The chemical vapor deposition reactor of claim 4, further wherein said plurality of side edge portions further comprise paired side edge portions, wherein a respective set of paired side edge portions comprises side edge portions of substantially the same curvature.

6. The chemical vapor deposition reactor of claim 5, still further wherein said paired side edge portions comprise curved side edge portions.

7. The chemical vapor deposition reactor of claim 5, still further wherein said paired side edge portions comprise straight side edge portions.

8. The chemical vapor deposition reactor of claim 5, still further wherein said paired side edge portions comprise at least one respective set of paired side edge portions comprising straight side edge portions and at least one respective set of paired side edge portions comprising curved side edge portions.

9. The chemical vapor deposition reactor of claim 3, wherein said positioning means comprises an adjustable means for spacing said equalizing means along a prescribed axis between a first prescribed distance and a second prescribed distance from said nozzle.

10. The chemical vapor deposition reactor of claim 3, wherein said positioning means comprises an adjustable means for translating said equalizing means in a plane perpendicular to the principal axis of said nozzle.

11. The chemical vapor deposition reactor of claim 3, wherein said positioning means comprises an adjustable means for pivoting said equalizing means about a prescribed point along an axis parallel to the principal axis of said nozzle.

12. The chemical vapor deposition reactor of claim 3, wherein said positioning means comprises an adjustable means for rotating said equalizing means about a prescribed axis between a first angular position and a second angular position.

13. The chemical vapor deposition reactor of claim 4, further wherein said positioning means comprises an adjustable means for spacing said equalizing means along a prescribed axis between a first prescribed distance and a second prescribed distance from said nozzle.

14. The chemical vapor deposition reactor of claim 4, further wherein said positioning means comprises an adjustable means for translating said equalizing means in a plane perpendicular to the principal axis of said nozzle.

15. A gas injector well suited for use in a chamber of a chemical vapor deposition reactor disposed opposite a susceptor upon which a substrate is supported during chemical deposition of a film upon a surface of the substrate from a reactant gas, said gas injector comprising:
a) a nozzle having an inlet port for receiving the reactant gas from a gas supply and an outlet port for releasing the reactant gas therethrough, the reactant gas undergoing a reactant chemistry and producing a flux of reactants within the chamber; and,
b) means for substantially equalizing a reactant chemistry and a flux of reactants uniformly across the surface of the substrate.

16. The gas injector of claim 15 wherein said equalizing means coupled to said nozzle to be intermediate said nozzle and the susceptor.

17. The gas injector well of claim 15 comprising:
c) means for positioning said equalizing means intermediate said nozzle and the susceptor, said positioning means coupling said equalizing means to said nozzle.

18. The gas injector of any claims 15 to 17, wherein said equalizing means comprises a plate having a contoured shape about its perimeter, the contoured shape characterized by a plurality of side edge portions, each of said side edge portions having a prescribed curvature, wherein at least two of said plurality of side edge portions do not form a part of a circle having a same finite radius.

19. The gas injector of claim 18, further wherein said plurality of side edge portions further comprise paired side dge portions, wherein a respective set of paired side edge portions comprises side edge portions of substantially the same curvature.

20. The gas injector of claim 19, still further wherein said paired side edge portions comprise curved side edge portions.

21. The gas injector of claim 19 still further wherein said paired side edge portions comprise straight side edge portions.

22. The gas injector of claim 19, still further wherein said paired side edge portions comprise at least one respective set of paired side edge portions comprising straight side edge portions and at least one respective set of paired side edge portions comprising curved side edge portions.
